Europäisches Patentamt

European Patent Office

Office européen des brevets

(11) Veröffentlichungsnummer: **0 292 636**
**A1**

(12) **EUROPÄISCHE PATENTANMELDUNG**

(21) Anmeldenummer: 88100348.7

(22) Anmeldetag: 13.01.88

(51) Int. Cl.4 **G01R 15/02 , G01R 21/08 , H01F 40/06**

(30) Priorität: 26.05.87 CH 2026/87

(43) Veröffentlichungstag der Anmeldung:
30.11.88 Patentblatt 88/48

(84) Benannte Vertragsstaaten:
**AT BE CH DE ES FR GB GR IT LI NL SE**

(71) Anmelder: **LGZ LANDIS & GYR ZUG AG**

**CH-6301 Zug(CH)**

(72) Erfinder: **Joder, Andreas**
**Binzenmatt 7**
**CH-6314 Unterägeri(CH)**
Erfinder: **Halder, Mathis**
**Burgmatt 28b**
**CH-6340 Baar(CH)**
Erfinder: **Seitz, Thomas**
**Hasenbühlweg 7**
**CH-6300 Zug(CH)**

(54) **Messwandler zum Messen des in einem elektrischen Leiter fliessenden Stromes.**

(57) Der Messwandler besteht aus einem drei-schenkligen ferromagnetischen Kern (2; 6), dessen Mittelschenkel (6) mindestens aus einem Steg (8; 6a; 7; 6b; 9) besteht und mindestens teilweise von einem elektrischen Leiter (1) U-förmig umgeben ist. Jeder Steg (8; 6a; 7; 6b; 9) besitzt mindestens drei Luftspalte (7, 8, 9), von denen alle ausser die beiden äusseren Luftspalte (8, 9) mindestens einen, im dargestellten Beispiel drei Magnetfeldsensoren (3, 3a, 3b) enthalten, die z. B. parallel nebeneinander angeordnet sind. Der Mittelschenkel (6) und die Magnetfeldsensoren (3, 3a, 3b) bilden zusammen eine Baueinheit. In jedem Steg ist jeder der beiden äusseren Luftspalte (8, 9), in der Längsrichtung des Mittelschenkels (6) gemessen, länger als die Sumpe der Längen aller anderen Luftspalte (7) des gleichen Stegs. Es sind total immer mindestens zwei Magnetfeldsensoren (3, 3a, 3b) im Mittelschenkel (6) vorhanden. Der Messwandler ist besonders gut geeignet zum kostensparenden Einbau in multifunktiona-len Messgeräten.

**Fig. 4**

## Messwandler zum Messen des in einem elektrischen Leiter fliessenden Stromes

Die Erfindung bezieht sich auf einen Messwandler zum Messen des in einem elektrischen Leiter fliessenden Stromes gemäss dem Oberbegriff des Anspruchs 1.

Derartige Messwandler werden mit Vorteil in multifunktionalen Messgeräten verwendet, wie z. B. in Elektrizitätszählern oder Leistungsmessern, die gleichzeitig zwei Arten Energie bzw. Leistung messen. Sie können ebenfalls verwendet werden, um einen Strom in Kombination mit einer anderen Messgrösse oder ein Stromquadrat sowie deren Zeitintegralen zu messen. In allen Fällen wird der Momentanwert eines elektrischen Stromes mit dem Messwandler gemessen und anschliessend mit dem Momentanwert einer Spannung multipliziert. Die Multiplikation erfolgt dabei in bevorzugter Weise mit Hilfe eines Hallelementes, das als Magnetfeldsensor zur Messung einer vom Strom erzeugten Magnetinduktion und damit der Strommessung dient.

Ein Messwandler der eingangs genannten Art ist aus dem Buch "Hallgeneratoren, Eigenschaften und Anwendungen," F. Kurth und H. J. Lippmann, Springer Verlag, 1968, Seiten 10 bis 11 und Seiten 267 bis 275 bekannt.

Der Erfindung liegt die Aufgabe zugrunde, unter Vermeidung des sonst üblichen teuren Aufwands an mehreren getrennten ferromagnetischen Kernen, einen Messwandler der eingangs genannten Art zu schaffen, der besonders gut geeignet ist zum kostensparenden Einbau in multifunktionalen Messgeräten oder in anderen Messgeräten, die mindestens zwei Magnetfeldsensoren benötigen und die mindestens einen Strommesswert auswerten.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werden im folgenden näher beschrieben.

Es zeigen:

Fig. 1 einen ersten Querschnitt A-B des Aufbaus eines Messwandlers, der in einem unifunktionalen Messgerät verwendbar ist,

Fig. 2 einen zweiten Querschnitt C-D des Aufbaus des in der Fig. 1 dargestellten Messwandlers,

Fig. 3 einen schematischen dritten Querschnitt E-F des Aufbaus des in der Fig. 1 dargestellten Messwandlers,

Fig. 4 einen schematischen Querschnitt E-F des Aufbaus einer ersten Variante des erfindungsgemässen Messwandlers,

Fig. 5 einen schematischen Querschnitt E-F des Aufbaus einer zweiten Variante des erfindungsgemässen Messwandlers,

Fig. 6 einen schematischen Querschnitt E-F des Aufbaus einer dritten Variante des erfindungsgemässen Messwandlers und

Fig. 7 ein Blockschaltbild eines multifunktionalen Messgerätes.

Gleiche Bezugszahlen bezeichnen in allen Figuren der Zeichnung gleiche Teile.

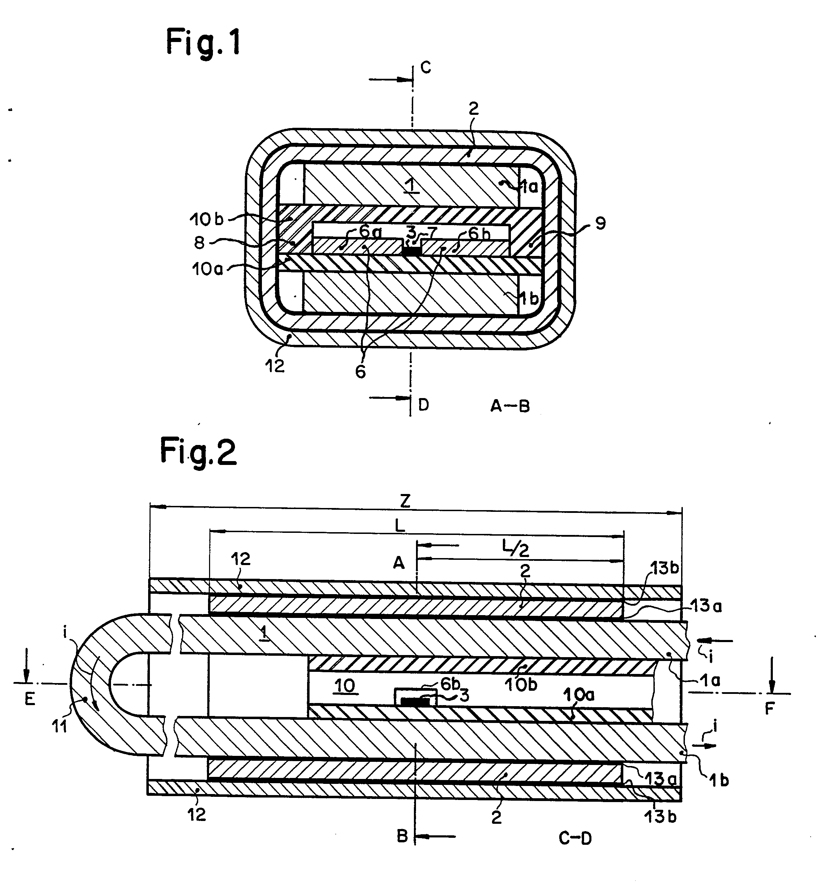

Der in den Figuren 1 bis 3 dargestellte Messwandler zum Messen des in einem elektrischen Leiter 1 fliessenden Stromes i enthält einen dreischenkligen ferromagnetischen Kern 2; 6 und einen Magnetfeldsensor 3, der vorzugsweise ein Hallelement ist. Der ferromagnetische Kern 2; 6 besteht vorzugsweise aus einem Ring 2 und einem Mittelschenkel 6. Die in der Darstellung der Zeichnung obere und untere Fläche des Ringes 2 bilden die beiden Aussenschenkel und die beiden seitlichen Flächen des Ringes 2 das Joch des dreischenkligen ferromagnetischen Kerns 2; 6, wobei das Joch die drei Schenkel jeweils an ihren beiden Enden miteinander verbindet. Als Material für den ferromagnetischen Kern 2; 6 eignet sich wegen der hohen Permeabilität vorzugsweise eine Eisen-Nickel-Legierung, wie z. B. Permenorm, Vacoperm, Trafoperm, Permax, Ultraperm oder Mumetall. Der Mittelschenkel 6 besitzt mindestens drei Luftspalte 7, 8 und 9, wovon der mittlere Luftspalt 7 den Magnetfeldsensor 3 enthält und die beiden äusseren Luftspalte 8 und 9 je an einem der beiden Enden des Mittelschenkels 6 angeordnet sind. Die Länge des mittleren Luftspaltes 7, in Längsrichtung des Mittelschenkels 6 gemessen, ist annähernd gleich gross wie die in gleicher Richtung gemessene Breite des Magnetfeldsensors 3, so dass sie genau durch diese Breite des Magnetfeldsensors 3 definiert ist. Jeder der beiden äusseren Luftspalte 8 und 9 ist, vorzugsweise in Längsrichtung des Mittelschenkels 6 gemessen, länger als der mittlere Luftspalt 7. Der Mittelschenkel 6 besteht vorzugsweise aus zwei flachen Blechstreifen 6a und 6b, die zusammen mit dem Magnetfeldsensor 3 in einem Gehäuse 10 aus nichtferromagnetischem Material, mit Vorteil aus Keramik, angeordnet sind. Das Gehäuse 10 besitzt vorzugsweise einen Boden 10a und einen Gehäusedeckel 10b. Der Mittelschenkel 6 und der Magnetfeldsensor 3 sind in vorteilhafter Weise auf einem Träger aus Isoliermaterial angeordnet, auf dem z. B. noch zusätzlich elektronische Bauelemente vorhanden sind, wobei vorzugsweise der Boden 10a des Gehäuses 10 dieser Träger ist. Dies gestattet eine einfache, präzise und zuverlässige Montage des Magnetfeldsensors 3 und des Mittelschenkels 6, die beide zusammen eine Baueinheit bilden, wobei diese beiden Komponenten so in einer andern Technologie hergestellt werden können als z. B. der restliche Teil des ferromagnetischen Kerns 2; 6. Die beiden äusseren Luftspalte 8 und 9 sind durch je eine Wand des Gehäuses 10 ausgefüllt, so dass ihre Luftspaltlängen genau durch die Wanddicke des Gehäuses 10 definiert werden können. Der Ring 2 besteht aus mindestens einem ringförmig gebogenen Blech, was seine Herstellung stark vereinfacht. Die Breite L des Ringes 2 ist grösser als seine grösste Lichtweite, so dass er den Magnetfeldsensor 3 sehr gut gegen die Wirkung äusserer Fremdmagnetfelder $\vec{H}_a$ abschirmt. Der elektrische Leiter 1 besitzt vorzugsweise einen rechteckförmigen Querschnitt und der Ring 2 ist dann auch in bevorzugter Weise rechteckförmig. Der Mittelschenkel 6 ist mindestens teilweise vom elektrischen Leiter 1 umgeben und vorzugsweise zwischen je einem in der Nähe parallel zueinander verlaufenden Hin- und Rückleiter 1a und 1b des elektrischen Leiters 1 angeordnet. Der elektrische Leiter 1 bildet z. B. eine U-förmige Schleife 11, deren Hin- und Rückleiter die parallel zueinander verlaufenden Hin- und Rückleiter 1a und 1b des elektrischen Leiters 1 sind. Der rechteckförmige Querschnitt des elektrischen Leiters 1 beträgt z. B. 2 mm • 10 mm für einen Strom i von 100A. Wird als Magnetfeldsensor 3 z. B. ein Hallelement verwendet, das Magnetfelder misst, die senkrecht zu seiner Oberfläche wirksam sind, dann füllt der Magnetfeldsensor 3 z. B. den Luftspalt 7 vollständig aus. Wird dagegen ein Hallelement verwendet, das Magnetfelder misst, die parallel zu seiner Oberfläche wirksam sind, dann füllt der Magnetfeldsensor 3 z. B. nur die untere Hälfte (siehe Fig. 1) des Luftspaltes 7 aus. Die Länge des Luftspaltes 7 beträgt z. B. 0,6 mm und diejenige der weiteren Luftspalte 8 und 9 z. B. je 1,7 mm. Auf dem Träger können innerhalb oder ausserhalb des Gehäuses 10a; 10b noch zusätzlich elektronische, nicht dargestellte Bauelemente angeordnet sein, die z. B. Teil der Beschaltungselektronik des Magnetfeldsensors 3 sind.

In der Fig. 1 wurde angenommen, dass die Breite des Gehäuses 10 grösser ist als die Breite des elektrischen Leiters 1. In diesem Fall füllt im Querschnitt A-B das Gehäuse 10 z. B. den Raum zwischen dem Hin- und Rückleiter 1a und 1b der Schleife 11 vollständig aus. Die Breite des Gehäuses 10 kann auch gleich oder kleiner sein als die Breite des elektrischen Leiters 1. Im letzten Fall füllt im Querschnitt A-B das Gehäuse 10 den Raum zwischen dem Hin- und Rückleiter 1a und 1b der Schleife 11 nur teilweise aus. In allen Fällen umgibt der Ring 2 der Breite L den Hin- und Rückleiter 1a und 1b der Schleife 11 sowie das Gehäuse 10 derart, dass der Mittelschenkel 6, parallel zu seiner Querrichtung gemessen, annähernd in der Mitte auf halber Entfernung L/2 vom Rand des Ringes 2 angeordnet ist (siehe Fig. 2). Der Hin- und der Rückleiter 1a und 1b der Schleife 11 durchqueren den Hohlraum zwischen dem Gehäuse 10 und dem Ring 2 z. B. derart, dass sie nach Möglichkeit sowohl räumlichen Kontakt mit dem Gehäuse 10a; 10b als auch elektrisch isolierten räumlichen Kontakt mit dem Ring 2 besitzen. Zwischen dem Ring 2 einerseits und dem Hin- und Rückleiter 1a und 1b der Schleife 11 anderseits ist somit eine Isolationsschicht 13a vorhanden (siehe Fig. 1 und Fig. 2).

Der Ring 2 ist vorteilhaft auf seiner Mantelfläche vollständig von einer annähernd parallelen ringförmigen und breiteren Aussenabschirmung 12 umgeben. Zwischen dem Ring 2 und der Aussenabschirmung 12 befindet sich z. B. eine Isolierschicht 13b. Die Aussenabschirmung 12 hat eine Breite Z, die grösser ist als die Breite L des Ringes 2, damit dessen stirnseitige Flächen noch teilweise mit abgeschirmt werden. Die Breite Z beträgt z. B. 30 mm. Die Aussenabschirmung 12 besteht vorteilhaft aus Tiefziehstahl oder aus einer Eisen-Nickel-Legierung. Die Isolierschicht 13b zwischen Ring 2 und Aussenabschirmung 12 dient hier auch dazu, den räumlichen Abstand zwischen den beiden zu vergrössern, was die Schirmwirkung der Aussenabschirmung 12 verbessert. Dieser räumliche Abstand beträgt z. B. 0,05 mm. Die Aufgabe der Aussenabschirmung 12 ist es, den hochpermeablen, aber leicht sättigenden Ring 2, der ja auch als Schirm wirksam ist, bei starken äusseren Fremdmagnetfeldern $\vec{H}_a$ zu entlasten. Der Ring 2 und die Aussenabschirmung 12 wirken somit als Doppelschirm. Ohne Aussenabschirmung 12 bleibt der durch den Ring 2 gebildete Schirm ungesättigt bis zu einem Wert des äusseren Fremdmagnetfeldes $\vec{H}_a$ von etwa 50A/cm. Beim Vorhandensein des Doppelschirms dagegen bleibt der durch den Ring 2 gebildete Schirm ungesättigt bis zu einem Wert des äusseren Fremdmagnetfeldes $\vec{H}_a$ von etwa 200A/cm.

Bei Verwendung einer Eisen-Nickel-Legierung für den Kern 2; 6 ist der magnetische Spannungsabfall am ferromagnetischen Material im Vergleich mit demjenigen am Luftspalt 7 bzw. an den Luftspalten 7, 8 und 9 vernachlässigbar. Dementsprechend wirken sich auch Nichtlinearität, Phasenfehler und Temperaturkoeffizient des hochpermeablen Materials nur geringfügig auf den Messwandler aus. Die Anordnung des Mittelschenkels 6 und des Magnetfeldsensors 3 auf einem Träger und/oder in einem Gehäuse 10 erlaubt eine besonders präzise, einfache und zuverlässige Montage des Messwandlers. Die Verwendung von drei Luftspalten 7, 8 und 9 gestattet es, alle Toleranzprobleme der Luftspaltlänge in den beiden äusseren Luftspalten 8 und 9 zu konzentrieren, wo sie am wenigsten stören, da dort die Magnetflusslinien nicht mehr parallel und dicht gepackt sind, sondern bereits teilweise auseinanderlaufen und ihren Weg durch den am ferromagnetischen Kern 2 angrenzenden Luftraum suchen. Diese Toleranzprobleme sind um so geringer, je stärker das Auseinanderlaufen der Magnetflusslinien ist, d. h. je länger die äusseren Luftspalte 8 und 9 sind.

Der in den Figuren 1 bis 3 dargestellte Messwandler für ein unifunktionales Messgerät besitzt einen aus einem einzigen Steg 8; 6a; 7; 6b; 9 bestehenden Mittelschenkel 6 des dreischenkligen ferromagnetischen Kerns 2; 6. Dieser Steg 8; 6a; 7; 6b; 9 besitzt zwei Blechstreifen 6a und 6b sowie drei Luftspalte 7, 8 und 9, wobei ein einziger Magnetfeldsensor 3 im mittleren Luftspalt 7 angeordnet ist.

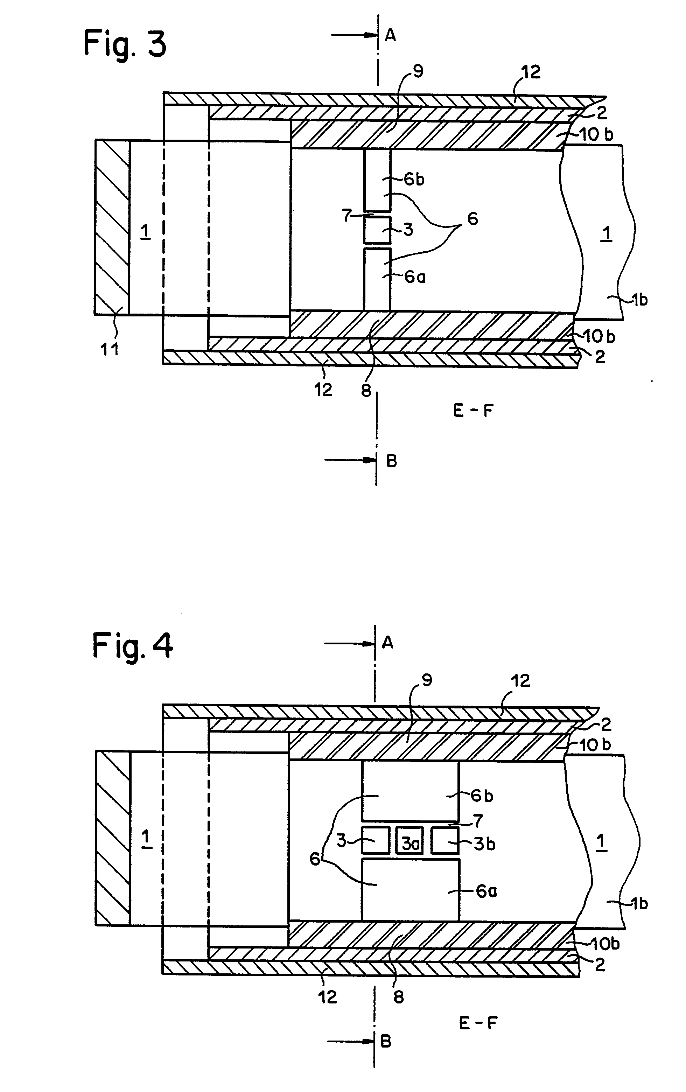

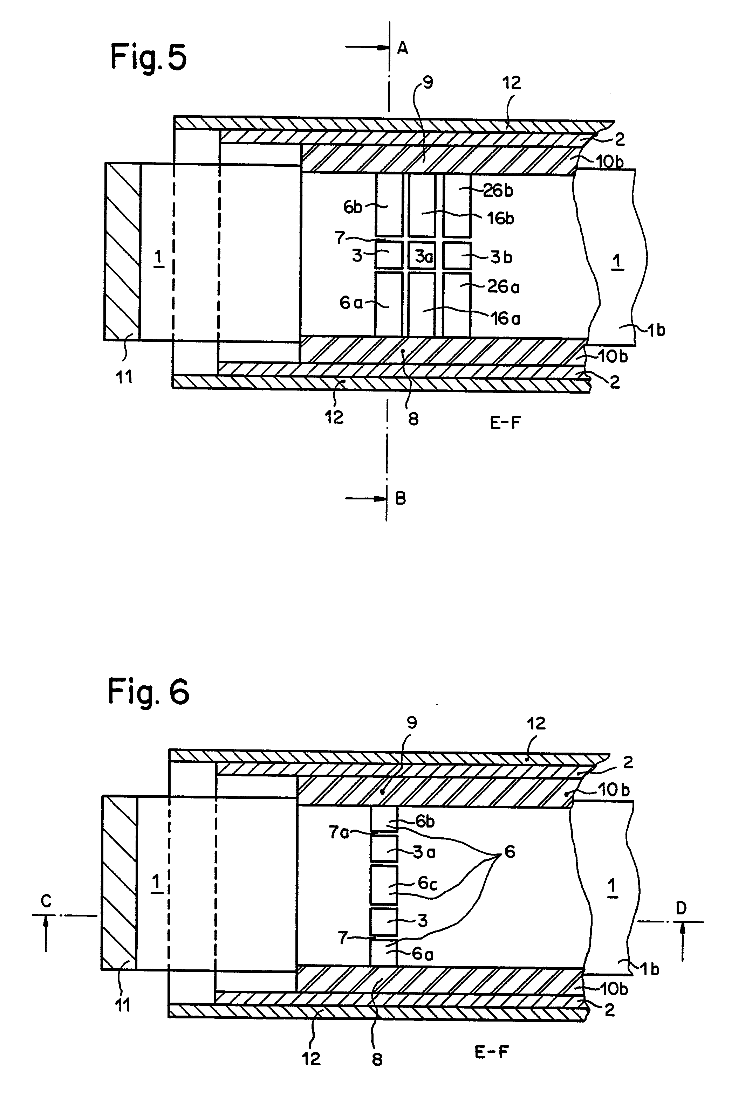

Soll ein derartiger Messwandler in einem multifunktionalen Messgerät verwendet werden, so werden total mindestens zwei Magnetfeldsensoren im Mittelschenkel 6 benötigt. Dieser besteht dann mindestens aus einem Steg, wobei jeder Steg mindestens drei Luftspalte besitzt, von denen alle ausser die beiden äusseren Luftspalte 8 und 9 eines jeden Stegs mindestens je einen Magnetfeldsensor enthalten. Als Beispiel wurde in den Figuren 4 und 5 das Vorhandensein dreier Magnetfeldsensoren 3, 3a und 3b und in der Fig. 6 das Vorhandensein zweier Magnetfeldsensoren 3 und 3a angenommen.

Die Figuren 1 und 4 stellen eine erste Variante des erfindungsgemässen Messwandlers dar, wobei der Mittelschenkel 6 aus einem einzigen Steg 8; 6a; 7; 6b; 9 besteht, der drei Luftspalte 7, 8 und 9 besitzt. Die Fig. 4 unterscheidet sich von der Fig. 3 dadurch, dass die Breite des einzigen vorhandenen Stegs 8; 6a; 7; 6b; 9 des Mittelschenkels 6, d. h. die Breite der Blechstreifen 6a und 6b, so breit gewählt ist, dass im zugehörigen mittleren Luftspalt 7 alle benötigten Magnetfeldsensoren 3, 3a und 3b parallel nebeneinander angeordnet werden können. Jeder der so nebeneinander angeordneten Magnetfeldsensoren 3, 3a und 3b misst den gleichen Strom i, der im elektrischen Leiter 1 fliesst.

Die Figuren 1 und 5 stellen eine zweite Variante des erfindungsgemässen Messwandlers dar. Die Fig. 5 unterscheidet sich von der Fig. 3 dadurch, dass der Mittelschenkel 6 aus in diesem Beispiel drei parallelen und voneinander getrennten Stegen besteht, nämlich aus einem ersten Steg 8; 6a; 7; 6b; 9, einem zweiten Steg 8; 16a; 7; 16b; 9 und einem dritten Steg 8; 26a; 7; 26b; 9. Alle drei Stege sind vorzugsweise gleichartig aufgebaut und gleichgross dimensioniert. D. h. jeder der drei Stege besteht mindestens aus zwei Blechstreifen 6a und 6b bzw. 16a und 16b bzw. 26a und 26b sowie aus mindestens drei Luftspalten 7, 8 und 9. Im mittleren Luftspalt 7 eines jeden Stegs ist mindestens ein Magnetfeldsensor 3 bzw. 3a bzw. 3b angeordnet. Auch hier misst jeder Magnetfeldsensor 3, 3a und 3b den gleichen, im elektrischen Leiter 1 fliessenden Strom i. In der Praxis sind bei der zweiten Variante immer mindestens zwei Stege 8; 6a; 7; 6b; 9 und 8; 16a; 7; 16b; 9 vorhanden.

Die Figuren 2 und 6 stellen eine dritte Variante des erfindungsgemässen Messwandlers dar, wobei der Mittelschenkel 6 aus einem einzigen Steg 8; 6a; 7; 6c; 7a; 6b; 9 besteht. Die Fig. 6 unterscheidet sich von der Fig. 3 dadurch, dass die Länge des einzigen Stegs 8; 6a; 7; 6c; 7a; 6b; 9 des Mittelschenkels 6 so lang gewählt ist, dass alle benötigten Magnetfeldsensoren, d. h. mindestens zwei Magnetfeldsensoren 3 und 3a, in Längsrichtung des Mittelschenkels 6 parallel hintereinander angeordnet werden können, wobei mit Vorteil zwischen zwei aufeinanderfolgenden Magnetfeldsensoren 3 und 3a fakultativ je ein weiterer Blechstreifen 6c (siehe Fig. 6) in der Verlängerung der Blechstreifen 6a und 6b angeordnet werden kann. Alle Blechstreifen 6a, 6b und 6c haben vorzugsweise einen gleichen Querschnitt. Ohne das Vorhandensein solcher weiterer Blechstreifen 6c besitzt der einzige Steg 8; 6a; 7; 7a; 6b; 9 des Mittelschenkels 6 mindestens drei Luftspalte 8, 9 und 7; 7a, wobei mindestens in einem der mittleren Luftspalte 7; 7a mehrere Magnetfeldsensoren 3 und 3a angeordnet sind. Beim Vorhandensein mindestens eines weiteren Blechstreifens 6c (siehe Fig. 6) besitzt der Steg 8; 6a; 7; 6c; 7a; 6b; 9 mindestens vier Luftspalte 7, 7a, 8 und 9, wobei in mindestens zwei der mittleren Luftspalte 7 und 7a je ein Magnetfeldsensor 3 bzw. 3a angeordnet ist. Der Magnetfeldsensor 3 befindet sich z. B. im Luftspalt 7 und der Magnetfeldsensor 3a im Luftspalt 7a. Die beiden Luftspalte 7 und 7a sind durch den fakultativ vorhandenen dritten Blechstreifen 6c voneinander getrennt. Auch hier messen alle Magnetfeldsensoren 3 und 3a den gleichen, im elektrischen Leiter 1 fliessenden Strom i.

Für alle drei Varianten des erfindungsgemässen Messwandlers gilt die Bedingung, dass in jedem Steg jeder der beiden äusseren Luftspalte 8 und 9, in der Längsrichtung des Mittelschenkels 6 gemessen, länger ist als die Summe der Längen aller anderen Luftspalte 7 und 7a des gleichen Stegs. Der Mittelschenkel 6 und alle benötigten Magnetfeldsensoren 3, 3a und 3b bilden zusammen in vorteilhafter Weise eine einzige Baueinheit. Der Mittelschenkel 6, alle Blechstreifen 6a, 6b und 6c sowie alle Magnetfeldsensoren 3, 3a und 3b sind vorzugsweise in dem einzigen Gehäuse 10 auf einem Träger aus Isoliermaterial angeordnet.

Der im Leiter 1 fliessende Strom i erzeugt eine Magnetinduktion B, die von allen Magnetfeldsensoren 3, 3a und 3b gemessen wird, so dass der Magnetinduktion-Messwert und damit auch der Strom-Messwert als elektrische Spannung u1 am Ausgang eines jeden der Magnetfeldsensoren 3, 3a und 3b ansteht, und dies obwohl jeweils nur ein einziger ferromagnetischer Kern 2; 6 vorhanden ist. Die multifunktionalen Messgeräte können somit bei Verwendung eines derartigen Messwandlers preisgünstig aufgebaut werden, da nicht mehr ein Kern pro gewünschte Funktion, sondern nur mehr ein einziger Kern für alle Funktionen zusammen benötigt wird.

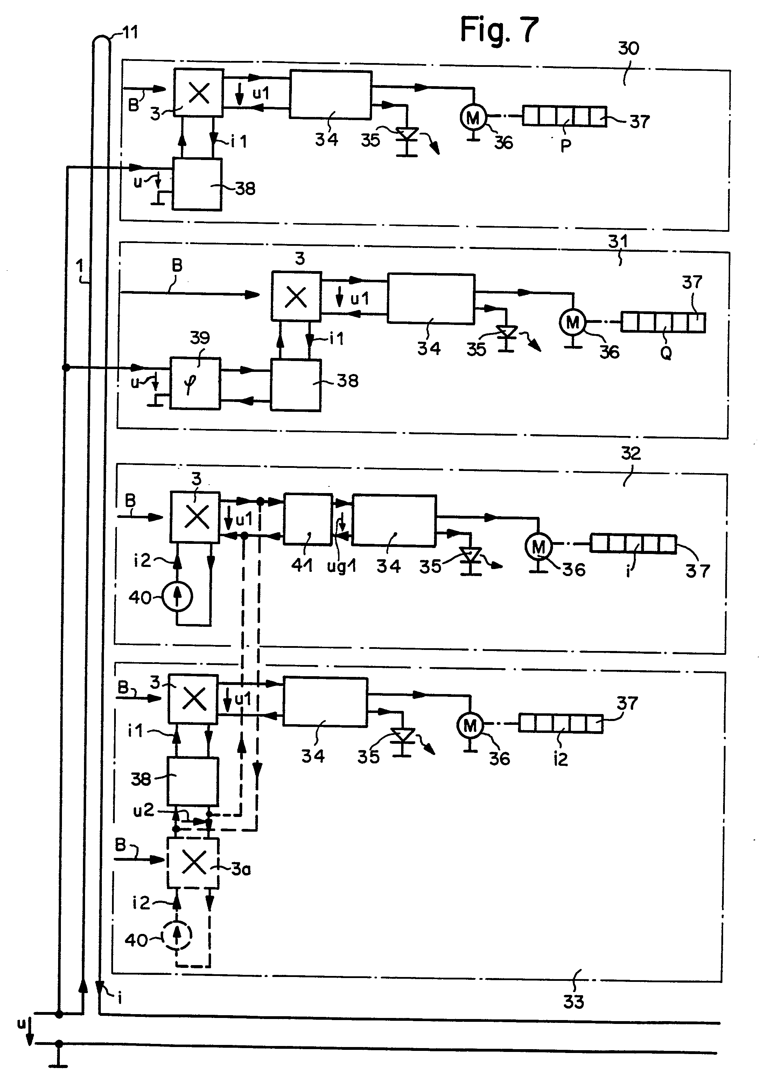

Im Blockschaltbild der Fig. 7 sind vier unifunktionale Messgeräte 30, 31, 32 und 33 dargestellt. Das erste Messgerät 30 stellt ein Wirkenergie- oder Wirkleistungs-Messgerät dar, z. B. ein bekannter Elektrizitätszähler. Das zweite Messgerät 31 stellt ein Blindenergie- oder Blindleistungs-Messgerät, das dritte Messgerät 32 ein Strom-Messgerät und das vierte Messgerät 33 ein Stromquadrat-Messgerät dar.

Die unifunktionalen Messgeräte 30, 31 und 33 sind ähnlich aufgebaut und besitzen alle als Grundausrüstung einen Magnetfeldsensor 3, dessen zweipoliger Ausgang auf einen zweipoligen Eingang eines Spannungs/Frequenz-Wandlers 34 geführt ist, wobei ein erster Ausgang des letzteren mit der Anode einer Leuchtdiode 35 und ein zweiter Ausgang mit einem ersten Speisepol eines Schrittmotors 36 verbunden ist. Der zweite Speisepol des Schrittmotors 36 und die Kathode der Leuchtdiode 35 liegen dabei jeweils an Masse, während der Schrittmotor seinerseits mechanisch eine mechanische Messwertanzeige 37 antreibt. In der Fig. 7 wurde jeweils das Vorhandensein einer fünfstelligen Ziffernanzeige angenommen. Statt einer elektromechanischen Messwert-Auswertung 36; 37 kann natürlich auch eine rein elektronische Anzeige verwendet werden: In diesem Fall fällt der Schrittmotor 36 weg.

Das Messgerät 32 besitzt dieselbe Grundausrüstung wie die Messgeräte 30, 31 und 33. Damit mit dem Messgerät 32 auch reine Wechselströme i (Mittelwert = 0) gemessen werden können, muss ein Brückengleichrichter 41 zwischen dem Magnetfeldsensor 3 und dem Spannungs/Frequenz-Wandler 34 geschaltet werden. Der Brückengleichrichter 41 wandelt die Ausgangsspannung u1 des Magnetfeldsensors 3 in eine proportionale Gleichspannung ug1 um, die dann dem Spannungs/Frequenz-Wandler 34 zugeführt wird.

In allen Messgeräten 30 bis 33 wandelt der Spannungs/Frequenz-Wandler 34 die Ausgangsspannung u1 des zugehörigen Magnetfeldsensors 3 bzw. ug1 des Brückengleichrichters 41 um in eine proportionale Frequenz eines in Funktion der Zeit rechteckförmigen Ausgangssignals des Spannungs/Frequenz-Wandlers 34. Dieses rechteckförmige Ausgangssignal erscheint an beiden Ausgängen des Spannungs/Frequenz-Wandlers 34.

Die Leuchtdiode 35 blinkt im Rhythmus der Ausgangsfrequenz des zugehörigen Spannungs/Frequenz-Wandlers 34 und dient jeweils als optischer Ausgang des zugehörigen Messgerätes. Der Wert ihrer Blinkfrequenz ist ein Mass für den Wert der Ausgangsspannung u1 des zugehörigen Magnetfeldsensors 3 bzw. ug1 des Brückengleichrichters 41 und kann mit einem nicht dargestellten, an sich bekannten optischen Messkopf gemessen und ausgewertet werden. Eine zweite, direkt mit dem Auge ablesbare Anzeige zeigt den integrierten Wert der Ausgangsfrequenz und damit den integrierten Wert der Ausgangsspannung u1 bzw. ug1 mit Hilfe des Schrittmotors 36 und der Anzeige 37 an. Je nachdem, ob die Ausgangsimpulse des Spannungs/Frequenz-Wandlers 34 über die Zeiteinheit oder über eine vorgegebene Messzeit integriert, d. h. gezählt werden, zeigt die Anzeige 37 den Messwert einer Leistung oder einer Energie an.

Mit dem Messgerät 30 wird eine Wirkleistung oder eine Wirkenergie gemessen, mit dem Messgerät 31 eine Blindleistung oder eine Blindenergie, mit dem Messgerät 32 der Strom i oder ein Produkt i.h und mit dem Messgerät 33 ein Stromquadrat $i^2$ oder ein Produkt $i^2.h$, wobei h die Anzahl Stunden bezeichnet, über denen integriert wird.

In der Darstellung der Fig. 7 stehen alle Magnetfeldsensoren 3 unter der Wirkung der gleichen Magnetinduktion B, die vom gleichen Strom i erzeugt wird. Der Strom i durchfliesst den Leiter 1, der vorzugsweise U-förmig gebogen ist und der alle Magnetfeldsensoren 3 mindestens teilweise umgibt. Dieser U-förmig gebogene Leiter 1 ist in der Fig. 7 nur schematisch dargestellt. Die zum Strom i gehörige Spannung, z. B. die Netzspannung, ist mit u bezeichnet und liegt mit einem Pol an Masse.

Das erste Messgerät 30 besitzt noch zusätzlich einen Spannungs/Strom-Wandler 38, dessen Eingang von der Spannung u gespeist wird. Der Spannungs/Strom-Wandler 38 wandelt die Spannung u um in einen proportionalen Strom i1, der das Hallelement des Magnetfeldsensors 3 speist. Da der Magnetfeldsensor 3 der Magnetinduktion B ausgesetzt ist, die proportional dem Strom i ist, ist die Ausgangsspannung u1 des Magnetfeldsensors 3 bekanntlich proportional dem Produkt i.u und der Ausgangs-Messwert des Messgerätes 30 entspricht dann der Wirkleistung oder der Wirkenergie.

Das zweite Messgerät 31 ist ähnlich aufgebaut wie das erste Messgerät 30 mit dem Unterschied, dass dem Spannungs/Strom-Wandler 38 noch ein Phasenschieber 39, z. B. ein 90˚-Phasenschieber, vorgeschaltet ist, dessen Eingang diesmal von der Spannung u gespeist ist, während der Ausgang des Phasenschiebers 39 zweipolig mit dem Eingang des Spannungs/Strom-Wandlers 38 verbunden ist. Sind der Strom i und die Spannung u Wechselgrössen und wird ein 90°-Phasenschieber verwendet, dann misst das zweite Messgerät 31 bekanntlich diesmal die Blindleistung oder die Blindenergie.

Das dritte Messgerät 32 besitzt zusätzlich zur Grundausrüstung noch eine Konstantstromquelle 40 und einen Brückengleichrichter 41. Die Konstantstromquelle 40 speist das Hallelement des Magnetfeldsensors 3 direkt mit einem konstanten Strom i2. Die Ausgangsspannung u1 des Magnetfeldsensors 3 wird mit dem Brückengleichrichter 41 in die proportionale Gleichspannung ug1 umgewandelt. Die Ausgangsspannung u1 des Magnetfeldsensors 3 und die Gleichspannung ug1 sind dann proportional der Magnetinduktion B und damit auch proportional dem z. B. zu messenden Strom i. Das dritte Messgerät 32 misst somit den Strom i oder das Produkt i.h.

Das vierte Messgerät 33 besitzt zusätzlich zur Grundausrüstung einen zweiten Magnetfeldsensor 3a, einen Spannungs/Strom-Wandler 38 und eine Konstantstromquelle 40. Die Konstantstromquelle 40 speist das Hallelement des zweiten Magnetfeldsensors 3a mit einem konstanten Strom i2, so dass eine Ausgangsspannung u2 des zweiten Magnetfeldsensors 3a, der auch der Magnetinduktion B ausgesetzt ist, proportional dem Strom i ist. Die Spannung u2 speist den Eingang des Spannungs/Strom-Wandlers 38, dessen Ausgangsstrom i1 das Hallelement des ersten Magnetfeldsensors 3 speist und selber proportional dem Strom i ist. Das Hallelement des ersten Magnetfeldsensors 3 wird vom Strom i1 gespeist und ist der Magnetinduktion B ausgesetzt, wobei sowohl B als auch i1 proportional i ist, so dass die Ausgangsspannung u1 des Magnetfeldsensors 3 proportional $i^2$ ist. Das vierte Messgerät 33 misst somit das Stromquadrat $i^2$ oder das Produkt $i^2$.h.

Ein multifunktionales Messgerät enthält mindestens zwei der in der Fig. 7 dargestellten unifunktionalen Messgeräte 30 bis 33. Ist in einem solchen multifunktionalen Messgerät sowohl ein Messgerät 32 als auch ein Messgerät 33 vorhanden, dann können für das Messgerät 33 die Konstantstromquelle 40 und der zweite Magnetfeldsensor 3a eingespart werden und an ihrer Stelle die Konstantstromquelle 40 und der Magnetfeldsensor 3 des Messgerätes 32 mitbenutzt werden. In diesem Fall ist die in der Fig. 7 gestrichelt dargestellte zweipolige Verbindung zwischen dem Messgerät 32 und dem Messgerät 33 oder konkreter ausgedrückt zwischen dem Ausgang des Magnetfeldsensors 3 des Messgerätes 32 und dem Eingang des Spannungs/Strom-Wandlers 38 des Messgerätes 33 notwendig. Die im Messgerät 33 gestrichelt dargestellten Bauelemente 3a und 40 sind dann überflüssig und können weggelassen werden.

Aber selbst wenn nur ein Messgerät 33 vorhanden ist, kann der erfindungsgemässe Messwandler verwendet werden, da das Messgerät 33 für sich allein bereits in der Regel zwei Magnetfeldsensoren 3 und 3a benötigt.

Das Messgerät 33 und die Messgerätekombinationen 30; 31, 30; 32, 30; 33, 31; 32, 31; 33, 32; 33, 30; 31; 32, 30; 31; 33, 30; 32; 33, 31; 32; 33 und 30; 31; 32; 33 stellen eine nicht erschöpfende Liste von möglichen Geräten dar, in denen ein erfindungsgemässer Messwandler verwendet werden kann.

Ein grosser Vorteil des Messgerätes 33 und aller oben erwähnten Messgerätekombinationen ist es, dass sie alle nur mehr einen einzigen Kern 2; 6 benötigen, dessen Mittelschenkel 6 so ausgebildet ist, dass in seinen Luftspalten 7 und 7a alle benötigten Magnetfeldsensoren 3, 3a und 3b so untergebracht werden können, dass sie alle über die Magnetinduktion B den gleichen Strom i messen.

## Ansprüche

1. Messwandler zum Messen des in einem elektrischen Leiter (1) fliessenden Stromes (i) mit einem dreischenkligen ferromagnetischen Kern (2; 6), dessen Mittelschenkel (6) mindestens aus einem Steg (8; 6a; 7/6c/7a; 6b; 9 bzw. 8; 16a; 7; 16b; 9 bzw. 8; 26a; 7; 26b; 9) besteht und mindestens teilweise vom elektrischen Leiter (1) umgeben ist, wobei jeder Steg (8; 6a; 7/6c/7a; 6b; 9 bzw. 8; 16a; 7; 16b; 9 bzw. 8; 26a; 7; 26b; 9) mindestens einen Luftspalt (7 bzw. 7a) enthält, in dem mindestens ein Magnetfeldsensor (3 bzw. 3a bzw. 3b) angeordnet ist, dadurch gekennzeichnet, dass jeder Steg (8; 6a; 7/6c/7a; 6b; 9 bzw. 8; 16a; 7; 16b; 9 bzw. 8; 26a; 7; 26b; 9) mindestens drei Luftspalte (7, 7a, 8, 9) besitzt, von denen alle ausser die beiden äusseren Luftspalte (8, 9) eines jeden Stegs mindestens je einen Magnetfeldsensor (3 bzw. 3a bzw. 3b) enthalten und wobei die beiden äusseren Luftspalte (8, 9) jeweils an einem der beiden Enden des Mittelschenkels (6) angeordnet sind, dass der Mittelschenkel (6) und die Magnetfeldsensoren (3, 3a, 3b) zusammen eine Baueinheit bilden, dass in jedem Steg jeder der beiden äusseren Luftspalte (8, 9), in der Längsrichtung des Mittelschenkels (6) gemessen, länger ist als die Summe der Längen aller anderen Luftspalte (7, 7a) des gleichen Stegs (8; 6a; 7/6c/7a; 6b; 9 bzw. 8; 16a; 7; 16b; 9 bzw. 8; 26a; 7; 26b; 9) und dass total mindestens zwei Magnetfeldsensoren (3, 3a, 3b) im Mittelschenkel (6) vorhanden sind.

2. Messwandler nach Anspruch 1, dadurch gekennzeichnet, dass der Mittelschenkel (6) aus einem einzigen Steg (8; 6a; 7; 6b; 9) besteht, der drei Luftspalte (7, 8, 9) besitzt, und dass alle Magnetfeldsensoren (3, 3a, 3b) im mittleren Luftspalt (7) nebeneinander angeordnet sind.

3. Messwandler nach Anspruch 1, dadurch gekennzeichnet, dass der Mittelschenkel (6) aus parallelen Stegen (8; 6a; 7; 6b; 9 und 8; 16a; 7; 16b; 9 und 8; 26a; 7; 26b; 9) besteht, die je mindestens drei Luftspalte (7, 8, 9) besitzen, wobei mindestens in einem der mittleren Luftspalten (7) eines jeden Stegs ein Magnetfeldsensor (3 bzw. 3a bzw. 3b) angeordnet ist.

4. Messwandler nach Anspruch 1, dadurch gekennzeichnet, dass der Mittelschenkel (6) aus einem einzigen Steg (8; 6a; 7; 7a; 6b; 9) besteht, der mindestens drei Luftspalte (8, 9 und 7; 7a) besitzt, wobei mindestens in einem der mittleren Luftspalte (7; 7a) mehrere Magnetfeldsensoren (3, 3a) angeordnet sind.

5. Messwandler nach Anspruch 1, dadurch gekennzeichnet, dass der Mittelschenkel (6) aus einem einzigen Steg (8; 6a; 7; 6c; 7a; 6b; 9) besteht, der mindestens vier Luftspalte (7, 7a, 8, 9) besitzt, wobei in mindestens zwei der mittleren Luftspalte (7, 7a) je ein Magnetfeldsensor (3 bzw. 3a) angeordnet ist.

6. Messwandler nach einem der Ansprüche 1 bis 5, dadurch gekennzeichnet, dass der Mittelschenkel (6) mindestens aus zwei flachen Blechstreifen (6a, 6b, 6c) besteht, die zusammen mit den Magnetfeldsensoren (3, 3a, 3b) in einem Gehäuse (10) aus nichtferromagnetischem Material angeordnet sind, und dass die beiden äusseren Luftspalte (8, 9) durch je eine Wand des Gehäuses (10) ausgefüllt sind.

7. Messwandler nach einem der Ansprüche 1 bis 6, dadurch gekennzeichnet, dass das Joch und die beiden Aussenschenkel des ferromagnetischen Kerns (2; 6) durch einen Ring (2) gebildet sind, der aus mindestens einem ringförmig gebogenen Blech besteht.

8. Messwandler nach einem der Ansprüche 1 bis 7, dadurch gekennzeichnet, dass der Mittelschenkel (6) zwischen je einem in der Nähe parallel zueinander verlaufenden Hin- und Rückleiter (1a, 1b) des elektrischen Leiters angeordnet ist.

9. Messwandler nach Anspruch 8, dadurch gekennzeichnet, dass der elektrische Leiter (1) eine U-förmige Schleife (11) bildet und dass deren Hin- und Rückleiter die parallel zueinander verlaufenden Hin- und Rückleiter (1a, 1b) des elektrischen Leiters (1) sind.

10. Messwandler nach einem der Ansprüche 7 bis 9, dadurch gekennzeichnet, dass der Ring (2) auf seiner Mantelfläche von einer annähernd parallelen, ringförmigen und breiteren Aussenabschirmung (12) umgeben ist.

# Fig.1

# Fig.2

PA 2378

# Fig. 3

A

9   12

2

10 b

6b

7   3   } 6

6a

1   1

1b

11   10 b

2

12   8

E - F

B

# Fig. 4

A

9   12

2

10 b

6b

7

3   3a   3b

6   1   1

6a

1b

10b

2

12   8

E - F

B

## Fig. 5

A

9    12

2

10b

26b

6b

16b

7

3    3a    3b

26a

6a    16a

1

1b

10b

2

11    12    8    E-F

B

## Fig. 6

9    12

2

10b

1

7a    6b

3a    6

7    6c    6

C    1    3    D

6a

11    12    8    E-F

1

1b

10b

2

## Fig. 7

| | Europäisches Patentamt | EUROPÄISCHER RECHERCHENBERICHT | Nummer der Anmeldung |
|---|---|---|---|

EP 88 10 0348

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,A | EP-A-0 233 988  (LGZ LANDIS & GYR ZUG AG) <br> * Ansprüche 1-3,7,8,17; Figuren 1,2 * <br> --- | 1,6-10 | G 01 R  15/02 <br> G 01 R  21/08 <br> H 01 F  40/06 |
| A | IEEE TRANSACTIONS ON POWER APPARATUS AND SYSTEMS, Band PAS-99, Nr. 3, Mai/Juni 1980, Seiten 1032-1037, IEEE; G.L. JOHNSON: "Hall effect measurement of real and reactive power in a Faraday machines laboratory" <br> * Seite 1032, rechte Spalte; Figur 1 * <br> --- | 1 | |
| A | FR-A-2 322 515  (GRUNDIG E.M.V. ELEKTROMECHANISCHE VERSUCHSANSTALT MAX GRUNDIG) <br> * Ansprüche 1,2; Figur 1 * <br> --- | 1 | |
| A | CA-A-  937 993  (CANADIAN GENERAL ELECTRIC CO.) <br> * Seite 3, Zeile 23 - Seite 4, Zeile 12; Figur 1 * <br> --- | 1 | |
| A | EP-A-0 030 041  (LGZ LANDIS & GYR ZUG AG) <br> * Seite 10, Zeile 29 - Seite 11, Zeile 8; Figur 14 * <br> ----- | 9,10 | RECHERCHIERTE SACHGEBIETE (Int. Cl.4) <br><br> G 01 R <br> H 01 F |

Der vorliegende Recherchenbericht wurde für alle Patentansprüche erstellt

| Recherchenort | Abschlußdatum der Recherche | Prüfer |
|---|---|---|
| DEN HAAG | 11-08-1988 | PENZKOFER,B. |